# EUROPÄISCHE PATENTANMELDUNG

(11) **EP 1 796 168 A2**
(43) Veröffentlichungstag der Anmeldung: **13.06.2007**
(21) Anmeldenummer: 06124199.8
(22) Anmeldetag: 16.11.2006
(51) Int. Cl.: H01L 27/146, H01L 31/0203

(54) **Optisches Modul sowie Verfahren zur Montage eines optischen Moduls**

(30) Priorität: 12.12.2005 DE 102005059161
(71) Anmelder: ROBERT BOSCH GMBH, 70442 Stuttgart (DE)
(72) Erfinder: Apel, Uwe, 72666 Neckartailfingen (DE); Keith, Stefan, 71272 Renningen (DE)

(57) **Zusammenfassung**

Die Erfindung geht aus von einem optischen Modul umfassend einen Linsenhalter (10) mit wenigstens einer Linse (11), ein Gehäuse (12) mit einer Montagefläche (13) sowie eine Bildsensoreinheit (14).

Es wird vorgeschlagen, dass der Linsenhalter (10) auf einer im montierten Zustand dem Gehäuse (12) zugewandten Seite einen umlaufenden Rand (15) aufweist, der in eine korrespondierende, in der Montagefläche (13) des Gehäuses (12) angeordneten Rinne (16) cinsctzbar ist.

Die Erfindung betrifft ferner ein Verfahren zur Montage eines optischen Moduls umfassend Komponenten aus einem Linsenhalter (10) mit wenigstens einer Linse (11), einem Gehäuse (12) mit einer Montagefläche (13), sowie eine Bildsensoreinheit (14).

## Beschreibung

### Stand der Technik

Die Erfindung geht aus von einem optischen Modul sowie einem Verfahren zur Montage eines optischen Moduls nach dem Oberbegriff der unabhängigen Ansprüche.

Nach dem Stand der Technik sind optische Module mit einer oder mehreren Linsen, einem Objektiv, einem Linsenhalter sowie einem Gehäuse bekannt. Üblicherweise werden die einzelnen optischen Bauteile nacheinander miteinander verbunden, und zwar die Linsen mit dem Objektiv, das Objektiv mit dem Linsenhalter und der Linsenhalter mit dem Gehäuse. Eine Verbindung zwischen Linsen und Objektiv wird üblicherweise mit einem Dichtungsring realisiert. Zur Fixierung des Objektivs am Linsenhalter ist meist ein Gewinde vorgesehen, wobei die Fokussierung des Objektivs durch Eindrehen in das Gewinde erfolgt. Der Linsenhalter wird mittels eines Klebstoffs mit dem Gehäuse, das meist als Keramikgehäuse ausgebildet ist, verbunden. Somit entstehen bei den herkömmlichen optischen Modulen drei sensible Fügestellen mit Dichtfunktion, und demnach drei kritische Leckpfade. Problematisch dabei ist, dass in der Praxis einsetzbare Klebstoffe und Dichtstoffe eine nicht zu vernachlässigende Wasserdampfdiffusion aufweisen. Es besteht somit die Gefahr eines Eintrags von Feuchtigkeit durch diese Wasserdampfdiffusion, wodurch die Lebensdauer der sich im Inneren des Moduls befindenden empfindlichen optischen Bauteile, wie beispielsweise des Bildsensoreinheitchips, reduziert wird.

In der Offenlegungsschrift EP 1 498 959 A2 wird ein Verfahren zur Herstellung einer Halbleitervorrichtung offenbart, wobei ein Versiegelungselement auf ein Substrat montiert wird, das das Halbleiterelement trägt. Das Versiegelungselement wird mit dem Substrat verklebt, wobei der Klebstoff anschließend ausgehärtet wird. Zum Ausgleich eines möglichen Druckanstiegs innerhalb der Halbleitervorrichtung während des Aushärtungsvorgangs wird eine Öffnung in dem Versiegelungselement vorgeschlagen. Zum Versiegeln der Halbleitervorrichtung wird die Öffnung anschließend wieder geschlossen.

### Offenbarung der Erfindung

Das erfindungsgemäße optische Modul umfasst einen Linsenhalter mit wenigstens einer Linse sowie ein Gehäuse mit einer Montagefläche und eine Bildsensoreinheit, wobei der Linsenhalter auf einer im montierten Zustand dem Gehäuse zugewandten Seite einen umlaufenden Rand aufweist, der in eine korrespondierende, in der Montagefläche des Gehäuses angeordneten Rinne einsetzbar ist. Die Rinne ist bevorzugt umlaufend ausgebildet und kann mit einem Dichtmittel, vorzugsweise einem Klebstoff, gefüllt sein, womit eine dichte Verbindung zwischen dem Linsenhalter und dem Gehäuse herstellbar ist.

Bevorzugt sind dabei die Linsen des Objektivs direkt mit dem Linsenhalter verbunden, beispielsweise über einen Dichtungsring oder über eine Klebung. Dadurch wird eine vormontierte Komponente gebildet, die vorzugsweise einstückig mit dem Gehäuse verbindbar ist.

Von besonderem Vorteil ist dabei, dass nur noch zwei geklebte Schnittstellen vorhanden sind und somit eine Anzahl von Fügestellen reduziert werden kann. Durch die Reduzierung dieser Fügestellen mit Dichtungswirkung können auch möglicherweise entstehende Leckpfade reduziert werden. Somit kann ein Eintrag von Feuchtigkeit, beispielsweise über Wasserdampfdiffusion, möglichst gering gehalten werden, was die Lebensdauer der empfindlichen optischen Bauteile erhöht. Zudem kann die Kondensation im Modul bei tiefen Temperaturen vermieden werden.

Bevorzugt werden als Baustoffe für die einzelnen Komponenten Keramik, Glas und/oder Metall eingesetzt, die günstigerweise keine Wasserdampfdiffusion aufweisen. Bei Gehäusekomponenten aus diesen Materialien wird zweckmäßigerweise die Montage und das Fokussieren mit effizienten und wirtschaftlichen Arbeitsschritten ermöglicht.

Bei einem erfindungsgemäßen Verfahren zur Montage eines solchen optischen Moduls wird ein umlaufender Rahmen des Linsenhalters in eine korrespondierende, in der Montagefläche des Gehäuses angeordnete, mit einem Dichtmittel, insbesondere einem Klebstoff, gefüllte Rinne gefügt.

Bevorzugt kann während des Fügeprozesses des Linsenhalters mit dem Gehäuse eine gewünschte Fokussierung der Linse automatisch eingestellt werden. Die gewünschte Fokussierung wird bevorzugt über eine während des Fügens aktiv betriebene Bildsensoreinheit ermittelt, die Testcharts erstellt. Die Bildfolge der Testcharts kann anschließend ausgewertet werden, um eine korrekte Fokussierung zu ermitteln. Von besonderem Vorteil dabei ist, dass die umständliche Fokussierung der Optik durch Eindrehen in ein Gewinde vermieden werden kann. Zudem wird mit diesem Verfahren günstigerweise eine sehr präzise Fokussierung erzielt.

In einer günstigen Weiterentwicklung des erfindungsgemäßen Verfahrens wird eine der vormontierten Komponenten, beispielsweise der Linsenhalter oder das Keramikgehäuse, beim Fügeprozess starr geklemmt oder fixiert, und die andere Komponente wird über eine geeignete dynamische Positioniervorrichtung, beispielsweise ein IAF (Image aligne fixture), ausgerichtet. Bevorzugt erfolgt die Ausrichtung so, dass die gewünschte Schärfeverteilung über dem Blickfeld erzielt wird. Günstigerweise kann gleichzeitig eine laterale Ausrichtung des Linsenhalters in Bezug auf das Gehäuse eingestellt werden, beispielsweise um ein Schiefblicken des optischen Moduls zu vermeiden.

In einer bevorzugten Ausgestaltung sind der Rand, insbesondere in seiner Höhe und Wandstärke, und die Rinne so dimensioniert, dass ein ausreichender Verfahrweg für die Fokussierung und eine korrekte laterale Ausrichtung gegeben sind. Somit kann vorzugsweise eine optische Ausrichtung automatisch eingestellt werden. Insbesondere kann das optische Modul selbstjustierend ausgebildet sein. Zudem kann zweckmäßigerweise ein langer Diffusionspfad erzielt werden. Möglichst lange Diffusionspfade sowie kleine Querschnittsflächen von Fügestellen mit Dichtfunktion leisten einen erheblichen Beitrag zur Reduktion der Wasserdampfdiffusion, so dass dieser Aspekt bei der Auslegung des Randes, insbesondere einer Höhe und Wandstärke des Randes, sowie der umlaufenden Rinne günstigerweise berücksichtigt werden kann.

Sind die jeweils vormontierten Teile, nämlich der Rand des Linsenhalters und die klebstoffgefüllte Rinne des Gehäuses, zueinander positioniert, erfolgt eine Schnellaushärtung des Dichtmittels mittels eines geeigneten Verfahrens, beispielsweise durch UV-Bestrahlung (UV-Curing) oder induktives Aushärten.

In einer bevorzugten Weiterentwicklung der Erfindung ist ein äußerer, um einen Gehäusekern des Gehäuses umlaufender Rahmen transparent ausgebildet. Der Rahmen ist bevorzugt aus Kunststoff gebildet. Diese Ausgestaltung ist insbesondere für das UV-Curing vorteilhaft, denn der so ausgestaltete äußere Rahmen ist für UV-Strahlung durchlässig, was den Aushärtungsprozess beschleunigt. Es kann dabei vorgesehen sein, dass der Rahmen um das herkömmliche Keramikgehäuse in Kunststoff angespritzt ist, oder die Keramik in einen Kunststoffrahmen eingepresst ist. Denkbar sind aber auch andere vergleichbare Glas-Keramik-Technologien. Der angespritzte Kunststoffrahmen ist bevorzugt so ausgestaltet, dass für die Handhabung während der Montage, der Fokussierung und des Tests geeignete Halteelemente angebracht sind, die beim endgeprüften Teil entfernt werden können.

In einer günstigen Weiterentwicklung tauchen im montierten Zustand der Linsenhalter und sein Rand in die Rinne ein. Dabei wird der Linsenhalter an seinem freien Ende vom Dichtmittel, insbesondere vom Klebstoff, umhüllt. Aufgrund der bevorzugten Kontur der Rinne liegt ein Teil der Klebenaht direkt zwischen dem Linsenhalter und dem (Keramik-)Gehäuse, auch wenn die Rinne für die Kleberfüllung durch einen transparenten Kunststoffrahmen ausgeführt wird. Damit wird eine besonders stabile Verbindung mit Dichtwirkung hergestellt. Außerdem wird durch die Verbindung ein langer Diffusionspfad bereitgestellt, wodurch die Verbindung vorteilhafterweise sehr diffusionsresistent ist.

Das erfindungsgemäße optische Modul wird vorzugsweise für Digitalkameras bzw. für Nachtsichtgeräte eingesetzt. Auch andere Anwendungsbereiche sind möglich.

### Zeichnungen

Weitere Ausführungsformen, Aspekte und Vorteile der Erfindung ergeben sich auch unabhängig von ihrer Zusammenfassung in Ansprüchen, ohne Beschränkung der Allgemeinheit aus nachfolgend anhand von Zeichnungen dargestellten Ausführungsbeispielen der Erfindung.

Im Folgenden zeigen:
- Fig. 1: eine schematische Ansicht einer bevorzugte Ausführungsform eines optischen Moduls; und
- Fig. 2: eine Draufsicht auf eine Montagefläche eines Gehäuses der Ausführungsform gemäß Fig. 1.

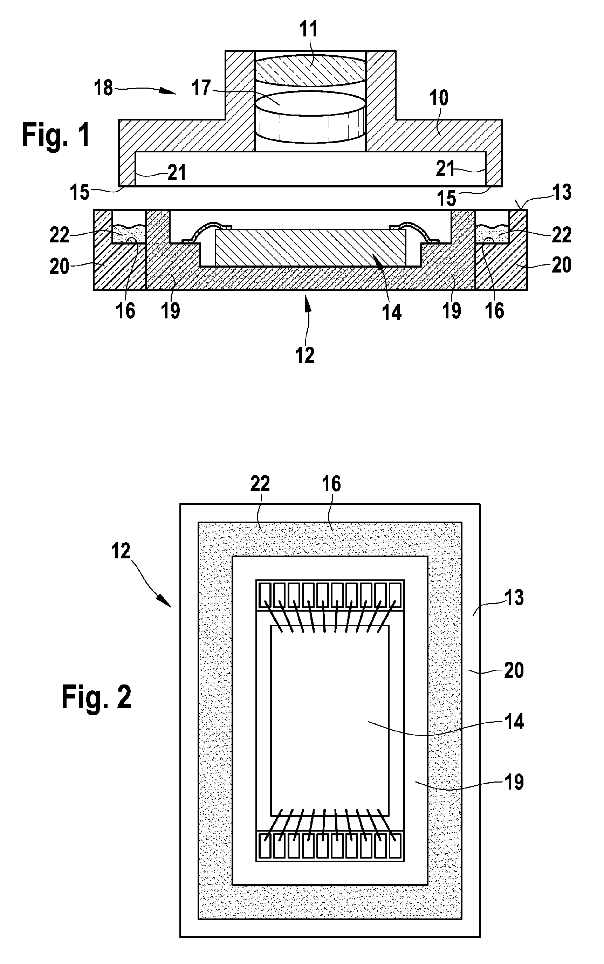

Fig. 1 zeigt in einer Explosionsdarstellung ein optisches Modul mit einem Linsenhalter 10 mit wenigstens einer Linse 11 sowie einem Gehäuse 12, vorzugsweise einem Keramikgehäuse. Ferner ist eine Bildsensoreinheit 14 vorgesehen mit einer Leiterplatte und einem Imager (Bildsensor), die jeweils nicht dargestellt sind. Der Imager umfasst wiederum ein nicht dargestelltes Imagerchip, z.B. mit lichtempfindlichem Silizium, und eine lichtdurchlässige Schutzabdeckung. Auf der Leiterplatte befinden sich die funktionsfähige Elektronik und ein Anschluss zur Übertragung von Daten, beispielsweise Bilddaten, und von Energie zum Betreiben der elektronischen Bauteile der Anordnung.

Die Linse 11 eines Objektivs 17 ist direkt mit dem Linsenhalter 10 verbunden. Dadurch entsteht eine vormontierte Komponente 18, die einstückig mit dem Gehäuse 12 verbunden werden kann.

Der Linsenhalter 10 weist auf einer im montierten Zustand dem Gehäuse 12 zugewandten Seite einen umlaufenden Rand 15 auf, der in eine korrespondierende, in der Montagefläche 13 des Gehäuses 12 angeordnete umlaufende Rinne 16 einsetzbar ist. Die Rinne 16 ist mit einem Dichtmittel 22, insbesondere einem Klebstoff, gefüllt. Bei der Montage wird so vorgegangen, dass die vormontierte Komponente 18 aus Linsenhalter 10 mit Linse 11 sowie das Gehäuse 12 so zueinander positioniert werden, dass der Rand 15 mit der klebstoffgefüllten Rinne 16 in Eingriff gebracht wird. Eine Klebstofffüllhöhe ist dabei so ausgelegt, dass der Klebstoff 22 während des Fügens des Randes 15 des Linsenhalters 10 nicht überläuft. Nach dem Fügeprozess erfolgt eine Schnellaushärtung des Klebstoffs 22 durch ein geeignetes Verfahren wie durch UV-Bestrahlung bzw. induktives Aushärten. Dieser Aushärtungsprozess wird dadurch beschleunigt, dass ein äußerer, um einen Gehäusekern 19 des Gehäuses 12 umlaufender Rahmen 20 transparent ausgebildet und somit für UV-Strahlung durchlässig ist. Der Rahmen 20 ist beispielsweise aus Kunststoff gebildet. Die Rinne 16 ist U-förmig ausgebildet, wobei ein innerer Schenkel aus dem Gehäusekern 19 gebildet ist, und der andere umfangsnahe Schenkel aus dem Rahmen 20.

Im montierten Zustand taucht der Linsenhalter 10 und sein Rand 15 in die Rinne 16 ein. Somit wird der Linsenhalter 10 an seinem freien Ende 21 vom Klebstoff 22 vollständig umhüllt. Die Basis der U-förmigen Rinne 16 ist aus dem transparenten Rahmen 20 gebildet und dient als Graben für die Kleberfüllung. Ein Teil der Klebenaht liegt im montierten Zustand zwischen dem Linsenhalter 10 und dem Gehäuse 12, insbesondere dem Gehäusekern 19.

Der Rand 15 und die Rinne 16 sind so dimensioniert, dass eine optische Ausrichtung automatisch einstellbar ist. Während des Fügens des Linsenhalters 10 mit dem Gehäuse 12 kann somit eine gewünschte Fokussierung der Linse 11 automatisch eingestellt werden. Dabei wird die gewünschte Fokussierung über die während des Fügens aktiv betriebene Bildsensoreinheit 14 ermittelt. Bei der Fokussierung wird eine der Komponenten aus Linsenhalter 10 oder Keramikgehäuse 12 starr fixiert und die andere der Komponenten 10 oder 12 über eine dynamische Positioniervorrichtung ausgerichtet. Gleichzeitig wird eine laterale Ausrichtung des Linsenhalters 10 in Bezug auf das Gehäuse 12 automatisch eingestellt.

Fig. 2 zeigt eine Draufsicht auf das Gehäuse 12 in Richtung auf eine Montagefläche 13, die in der Bildebene angeordnet ist. Auf der Montagefläche 13 des Gehäuses 12 ist eine umlaufende Rinne 16 angeordnet, in die ein nicht gezeigter korrespondierender Rand 15 eines Linsenhalters 10 eingesetzt wird. Die Rinne 16 ist mit Klebstoff 22 gefüllt. Der äußere (Kunststoff-)Rahmen 20 ist transparent und somit für UV-Strahlung durchlässig, wodurch ein nach dem Fügen stattfindender Aushärtungsprozess gefördert wird. Die Innenseite der Rinne 16 wird durch einen Gehäusekern 19 gebildet. In einem Zentralbereich ist eine Bildsensoreinheit 14 angeordnet.

## Patentansprüche

1. Optisches Modul umfassend einen Linsenhalter (10) mit wenigstens einer Linse (11), ein Gehäuse (12) mit einer Montagefläche (13) sowie eine Bildsensoreinheit (14), **dadurch gekennzeichnet, dass** der Linsenhalter (10) auf einer im montierten Zustand dem Gehäuse (12) zugewandten Seite einen umlaufenden Rand (15) aufweist, der in eine korrespondierende, in der Montagefläche (13) des Gehäuses (12) angeordneten Rinne (16) einsetzbar ist.

2. Modul nach Anspruch 1, **dadurch gekennzeichnet, dass** die Rinne (16) mit einem Dichtmittel (22) gefüllt ist.

3. Modul nach Anspruch 2, **dadurch gekennzeichnet, dass** das Dichtmittel (22) ein Klebstoff ist.

4. Modul nach einem der vorhergehenden Ansprüche, **dadurch gekennzeichnet, dass** ein äußerer, um einen Gehäusekern (19) des Gehäuses (12) umlaufender Rahmen (20) transparent ausgebildet ist.

5. Modul nach einem der vorhergehenden Ansprüche, **dadurch gekennzeichnet, dass** im montierten Zustand der Linsenhalter (10) und sein Rand (15) in die Rinne (16) eintauchen.

6. Modul nach einem der vorhergehenden Ansprüche, **dadurch gekennzeichnet, dass** der Rand (15) und die Rinne (16) so dimensioniert sind, dass eine optische Ausrichtung automatisch einstellbar ist.

7. Verfahren zur Montage eines optischen Moduls umfassend einen Linsenhalter (10) mit wenigstens einer Linse (11), ein Gehäuse (12) mit einer Montagefläche (13), sowie eine Bildsensoreinheit (14), **dadurch gekennzeichnet, dass** ein umlaufender Rand (15) des Linsenhalters (10) in eine korrespondierende, in der Montagefläche (13) des Gehäuses (12) angeordnete, mit einem Dichtmittel (22), insbesondere einem Klebstoff, gefüllte Rinne (16) gefügt wird.

8. Verfahren nach Anspruch 7, **dadurch gekennzeichnet, dass** die Linse (11) eines Objektivs (17) direkt mit dem Linsenhalter (10) verbunden werden, wodurch eine vormontierte Komponente (18) entsteht, die einstückig mit dem Gehäuse (12) verbunden wird.

9. Verfahren nach Anspruch 7 oder 8, **dadurch gekennzeichnet, dass** während des Fügens des Linsenhalters (10) mit dem Gehäuse (12) eine gewünschte Fokussierung der Linse (11) automatisch eingestellt wird.

10. Verfahren nach Anspruch 9, **dadurch gekennzeichnet, dass** die gewünschte Fokussierung über die während des Fügens aktiv betriebene Bildsensoreinheit (14) ermittelt wird.

11. Verfahren nach einem der vorhergehenden Ansprüche 7 bis 10, **dadurch gekennzeichnet, dass** eine der Komponenten (10, 12, 18) starr fixiert wird und die andere Komponente (10, 12, 18) über eine dynamische Positioniervorrichtung ausgerichtet wird.

12. Verfahren nach einem der vorhergehenden Ansprüche 7 bis 11, **dadurch gekennzeichnet, dass** nach dem Fügeprozess eine Schnellaushärtung des Dichtmittels (22) erfolgt.
